# EUROPEAN PATENT SPECIFICATION

(11) **EP 2 395 555 B1**
(45) Date of publication and mention of the grant of the patent: **10.03.2021**
(21) Application number: 10190605.5
(22) Date of filing: 10.11.2010
(51) Int. Cl.: H01L 31/02, H02S 20/00, H02S 40/36, H02S 40/34, H01L 31/05

(54) **Solar module support and solar cell module**
Solarmodulträger und Solarzellenmodul
Support de module solaire et module de cellules solaires

(30) Priority: 08.06.2010 TW 099118571
(43) Date of publication of application: 14.12.2011
(73) Proprietor: United Renewable Energy Co., Ltd., Hsinchu (TW)
(72) Inventor: Tung, Kuan-Wen, 324, Taoyuan County (TW); Chen, Chien-Chun, 300, Hsinchu City (TW)
(74) Representative: Straus, Alexander

(56) References cited:
- EP-A2- 0 902 485
- WO-A1-2009/076740

## Description

The invention relates to a solar module support having a switching circuit capable of being controlled by a solar cell module, and a solar cell module thereof according to the precharacterizing clauses of claims 1 and 8, respectively.

In the technical field of solar energy conversion, solar cells, also referred to as "photovoltaic cells," are well known devices for converting solar radiation to electrical energy. They may be fabricated on a semiconductor wafer using semiconductor processing technology. Generally speaking, a solar cell may be fabricated by forming p-doped and n-doped regions in a silicon substrate. Solar radiation impinging on the solar cell creates electrons and holes that migrate to the p-doped and n-doped regions, thereby creating voltage differentials between the doped regions.

In order to construct a photovoltaic power generation system in which a high current and high voltage is required, a plurality of solar cells are in serial or parallel connection to obtain the desired output current and output voltage.

The solar cell is susceptible to corrosion and easily broken by a shock from an external source. Therefore, the connected solar cells are sandwiched and laminated between a front sheet and a back sheet to form a solar cell module. An adhesive layer is disposed between the front sheet and the back sheet and encapsulated the solar cells. The adhesive layer is for adhering the front sheet to the back sheet. A plurality of solar cell modules can electrically connect to each other to form a solar cell array.

However, after a period of time of usage, the solar cell in the solar cell module may be damaged by outdoor conditions. European Patent Application EP 0902485A2 provides a non-contact space between electric connecting members and the underlaying material or substrate material of a solar cell module, which helps to prevent temporal degradation of the solar cell module. A vinyl chlorine resin is used as a casing material for the electric connecting members. The flexibility of the casing material helps prevent the electric connecting members from being disengaged from the solar cells.

Since solar cells in the solar module are usually in serial connection, when one of the solar cells does not function, the entire string of the solar cells are not workable. Therefore, a new solar cell must be inserted to replace the damaged one to maintain the serial connection, or the entire solar cell module including the damaged solar cell and the workable solar cell needs to be replaced, which is a waste. The repair methods require removing the front sheet. Subsequently, the defective solar cell is removed from the back sheet. Then, a new solar cell is inserted into the repair site. Such replacement of solar cells may damage the back sheet and the adjoining solar cells, and requires high expenditures.

This in mind, the invention aims at providing a solar cell module which can be replaced at lower expenditure and a solar module support which keeps the serial solar cells working even when one of the solar cells in the string is pulled out from
the solar module support.

This is achieved by a solar module support and a solar cell module, according to claims 1 and 8 respectively.

The dependent claims pertain to corresponding further developments and improvements.

As will be seen more clearly from the detailed description below, the solar module support further comprises: a substrate; a first switching circuit configured in the substrate comprising two L-shaped wire segments, two resilient members and a bridging wire segment; and a first solar module socket embedded in the substrate for fixing a first solar cell module, wherein when the first solar cell module is engaged with the first solar module socket, the resilient members are pressed down so that the L-shaped wire segments are separated from the bridging wire segment, the first switching circuit is turned off and a first current passes through the first solar cell module, and when the first solar cell module detaches from the first solar module socket, the resilient members return to their original respective positions so that the L-shaped wire segments connect to the bridging wire segment and a second current passes through the first switching circuit.

The switching circuit serves as a bypass when the solar cell module is pulled out from the solar module support. Therefore, the serial connection of the solar cell array can still function well.

Furthermore, the arrangement of the solar cell modules on the solar module support can be customized to form a desired pattern. For example, a symbol of a company can be pieced together by placing solar cell modules in the designated sockets.

As detailed in the description below, the solar cell module comprises: a back sheet; a front sheet disposed on the back sheet; at least one solar cell disposed between the front sheet and the back sheet; an adhesive layer encapsulating the at least one solar cell; an anode wire penetrating the adhesive layer and the back sheet; a cathode wire penetrating the adhesive layer and the back sheet; and two plugs, where the anode wire is inserted into one plug and the cathode wire is inserted into the other plug. The plugs are capable of being fixed on the solar module support described above.

In the following, the invention is further illustrated by way of example, taking reference to the following drawings.

Thereof:
FIG. 1 is a schematic diagram depicting a solar module support according to a preferred embodiment of the present invention;
FIG. 2A shows a top view of the structure of a solar cell module according to a preferred embodiment of the present invention schematically;
FIG. 2B shows a sectional view of the solar cell module taken
   along line AA' in FIG. 2A;
FIG. 3 is a schematic diagram depicting a turned off switching circuit when the solar cell module is engaged with the solar module support; and
FIG. 4 is a schematic diagram of FIG. 1 depicting a turned on switching circuit when the solar cell module is detached from the solar module support.

### DETAILED DESCRIPTION

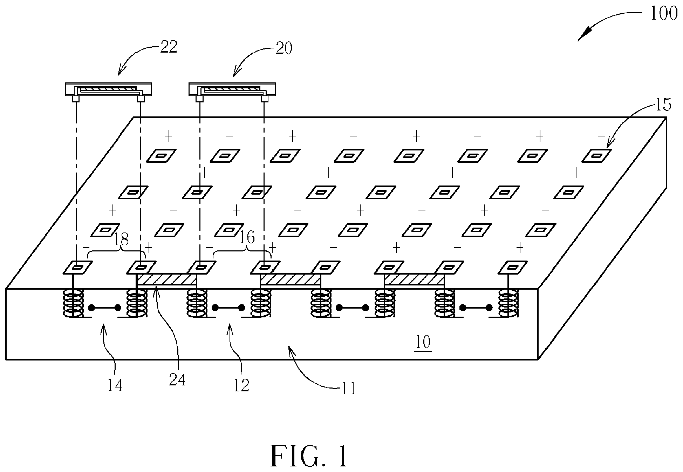

FIG. 1 is a schematic diagram depicting a solar module support according to a preferred embodiment of the present invention. As shown in FIG. 1, a solar module support 100 includes a substrate 10. The substrate 10 may be a case having a cavity within. A plurality of switching circuits 11 such as a first switching circuit 12 and a second switching circuit 14 are configured inside the substrate 10. The top surface or the bottom surface of the substrate 10 may have numerous springs disposed thereon (not shown) and posts (not shown) for routing the switching circuits. It is noteworthy that the solar module support 100 further includes numerous solar module sockets 15, such as a first and a second solar module socket 16, 18 embedded in the top surface of the substrate 10. The first and the second solar module sockets 16, 18 are for fixing or installing a first solar cell module 20 and a second solar cell module 22, respectively. Other solar module sockets are capable of fixing or installing other solar cell modules. The first switching circuit 12 may be composed of resilient members and wire segments. The second switching circuit 14 may have the same configuration as the first switching circuit 12. An interconnection circuit 24 is configured inside the substrate 10 and electrically connects the adjacent switching circuits or the adjacent solar modules. The structures of the first and second switching circuits 12, 14 are described in greater detail later; a brief description is provided now to aid in the understanding of the structure solar module support 100.

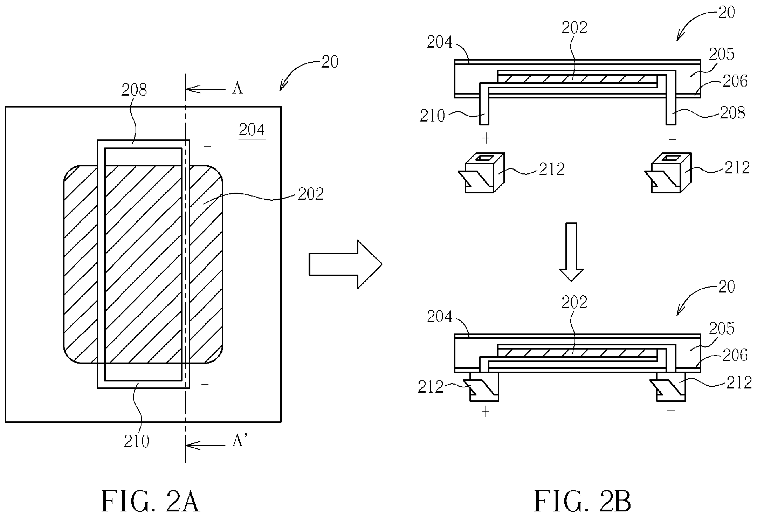

FIG. 2A shows a top view of the structure of a solar cell module according to a preferred embodiment of the present invention schematically. FIG. 2B shows a sectional view of the solar cell module taken along line AA' in FIG. 2A.

Please refer to both FIG. 2A and FIG. 2B. The first solar cell module 20 includes at least one solar cell 202. A front sheet 204 and a back sheet 206 sandwich the solar cell 202. An adhesive layer 205 encapsulates the solar cell 202. The adhesive layer 205 can be ethylene vinyl acetate (EVA) for adhering the solar cell 202, the front sheet 204, and the back sheet 206. Although only one solar cell 202 is disposed in the first solar cell module 20, more than one solar cell can be packaged together to become the first solar cell module 20. An anode wire 210 and a cathode wire 208, which serve as electrodes, extend from the surface of the solar cell module 20 and penetrate the adhesive layer 205, and the back sheet 206. Alternatively, the anode wire 210 and the cathode wire 208 can extend from the side surface of the solar cell module 20. Then, the anode wire 210 and the cathode wire 208 can be bent toward the back sheet 206. After that, the anode wire 210 and the cathode wire 208 are inserted into plugs 212 respectively. The plugs 212 are advantageously substantially perpendicular to the back sheet 206. Furthermore, the plug 212 with the anode wire 210 inside may have different features from the other plug 212 with cathode wire 208 inside. For instance, the plug 212 with the anode wire 210 inside may be blue color, and the plug 212 with cathode wire 208 inside may be green color. The plugs 212 may be any plugs which can fix the solar cell module 20 tightly on the solar module support. For example, the plugs may be analogous to phone plugs, Ethernet cable plugs or other types of plugs, but not limited thereto. The free ends of the plugs 212 can expose the end point of the anode wire 210 and the end point of the cathode wire 208. Although only the structure of the first solar cell module 20 is described, the aforesaid second solar cell module 22, and other solar cell modules utilized in the present invention have a structure that is identical with the first solar cell module 20.

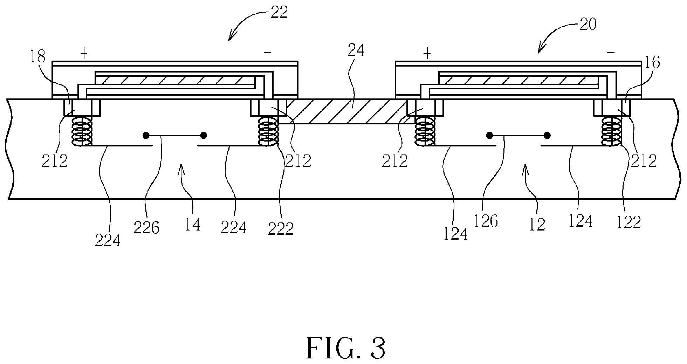

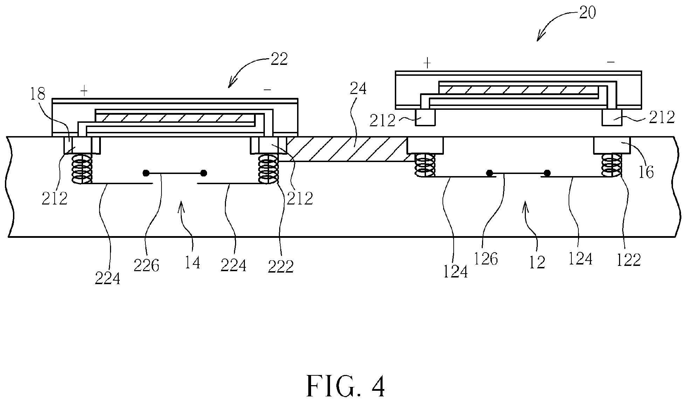

FIG. 3 is a schematic diagram depicting a turned off switching circuit when the solar cell module is engaged with the solar module support. FIG. 4 is a schematic diagram of FIG. 1 depicting a turned on switching circuit when the solar cell module is detached from the solar module support. For the sake of simplicity, only two switching circuits are shown in FIG. 3 and FIG. 4. However, it should be understood that all the switching circuits 11 on the solar module support 100 can be operated in the same way.

Please refer to FIGS. 1-3. The first solar cell module 20 is engaged with the substrate 10, and the second solar cell module 22 is also engaged with the substrate 10. By plugging the plugs 212 on the first solar cell module 20 into the first solar module socket 16, the plugs 212 interlock with the first solar module socket 16. More particularly, the first solar module socket 16 has two individual recesses. Each individual recess corresponds to an anode and a cathode respectively. The plug 212 with anode wire 210 inside should be plugged into the anode recess, and the plug 212 with cathode wire 208 inside should be plugged into the cathode recess.

When the first solar cell module 20 is engaged with the substrate 10, the first switching circuit 12 is turned off, and no current can flow through the first switching circuit 12. The first switching circuit 12 includes two L-shaped wire segments 124, two resilient members 122 and a bridging wire segment 126. The second switching circuit 14 includes two L-shaped wire segments 224, two resilient members 222 and a bridging wire segment 226.

According to a preferred embodiment of the present invention, when the first solar cell module 20 is plugged into the first solar module socket 16, the resilient members 122 of the first switching circuit 12 is pressed down, and two L-shaped wire segments 124 are separated from a bridging wire segment 126. The first switching circuit 12 is therefore turned off. At this point, the first and the second solar cell modules 20, 22 are in serial connection. The current provided by the second solar cell module 22 flows through the L-shaped wire segments 224, interconnection circuit 24, and the L-shaped wire segment 124 to the cathode wire 208 of the first solar cell module 20. The interconnection circuit 24 connects to the L-shaped wire segment 224 of the second switching circuit 14 to the L-shaped wire segment 124 of the first switching circuit 12.

As shown in FIGS. 1-2 and 4, the first solar cell module 20 is detached from the substrate 10, and the second solar cell module 22 is still engaged with the substrate 10. When the first solar cell module 20 is detached from the substrate 10, the first switching circuit 12 is turned on, and a current flowing from the second solar cell module 22 can flow through the L-shaped wire segment 224, and the interconnection circuit 24 to the first switching circuit 12. When the first solar cell module 20 is pulled out from the first solar module socket 16, the resilient members 122 of the first switching circuit 12 spring back to their original positions, and the L-shaped wire segments 124 reconnect to the bridging wire segment 126.

Although FIG. 3 and FIG. 4 merely describe the plug in and pull out operations of the first solar cell module 20 associated with the first switching circuit 12, the second switching circuit 14 is controlled in the same way as the first switching circuit 12. That is, when the second solar cell module 22 is plugged in, the second switching circuit 14 is turned off and when the second solar cell module 22 is pulled out, the second switching circuit 14 is turned on. Furthermore, each of the solar module sockets 15 on the solar module support 100 can be plugged in with one solar cell module to supply greater voltage.

The solar cell module of the present invention offers an easy way to replace a defective solar cell module. Merely by plugging in and out, the solar cell module can be engaged with the solar module support or detached from the solar module support. Furthermore, when the solar cell module is pulled out, the switching circuit corresponding to it turns on to maintain the serial circuit. Even when there is no new solar cell module to plug in for replacing the broken one, the serial circuit can still function as long as the broken solar cell module is pulled out. Moreover, since there is merely a single solar cell in one solar cell module, when the solar cell is damaged, the entire solar cell module can be replaced without peeling off the front sheet. Therefore, the expenditures of replacement of solar cell module are saved. Furthermore, the arrangement of the solar cell modules on the solar module support can be customized to form a desired pattern. For example, a symbol of a company can be pieced together by placing solar cell modules in their designated sockets.

## Claims

1. A solar module support (100), comprising:
a substrate (10); and **characterized by**:
a first switching circuit (12) configured in the substrate (10), comprising:
two L-shaped wire segments (124);
two resilient members (122); and
a bridging wire segment (126); and
a first solar module socket (16) disposed in the substrate (10) for installing a first solar cell module (20), wherein when the first solar cell module (20) is engaged with the first solar module socket (16), the resilient members (122) are pressed down so that the L-shaped wire segments (124) are separated from the bridging wire segment (126) and a first current passes through the first solar cell module (20), and when the first solar cell module (20) detaches from the first solar module socket (16), the resilient members (122) return to their original respective positions so that the L-shaped wire segments (124) connect to the bridging wire segment (126) and a second current passes through the first switching circuit (12).

2. The solar module support (100) of claim 1, further **characterized by** a second switching circuit (14) configured in the substrate (10), and a second solar module 20 socket (18) disposed in the substrate (10) for installing a second solar cell module (22).

3. The solar module support (100) of claim 2, **characterized in that** when the first solar cell module (20) is engaged with the first solar module socket (16), the first current passing through the first solar cell module (20) is provided by the second solar cell module (22) and the first solar cell module (20).

4. The solar module support (100) of claim 2, **characterized in that** when the first solar cell module (20) detaches from the first solar module socket (16), the second current passing through the first switching circuit (12) is provided by the second solar cell module (22).

5. The solar module support (100) of claim 2, further **characterized by** an interconnection circuit (24) configured on the substrate (10) and the interconnection circuit (24) electrically connects the first switching circuit (12) with the second solar cell module (22).

6. The solar module support (100) of claim 2, further **characterized by** an interconnection circuit (24) configured on the substrate (10) and the interconnection circuit (24) electrically connects the first solar cell module (20) with the second solar cell module (22).

7. The solar module support (100) of claim 1, **characterized in that** the first solar cell module (20) further comprises two plugs (212), and the plugs (212) are capable of plugging into the first solar module socket (16) so as to interlock the first solar cell module (20) on the substrate (10).

8. A solar cell module (20) configured to be fixed on the solar module support (100) of Claim 1, comprising:
a back sheet (206);
a front sheet (204) disposed on the back sheet (206);
at least one solar cell (202) disposed between the front sheet (204) and the back sheet (206); and
an adhesive layer (205) encapsulating the at least one solar cell (202); and **characterized by:**
an anode wire (208) penetrating the adhesive layer (205) and the back sheet (206);
a cathode wire (210) penetrating the adhesive layer (205) and the back sheet (206); and
two plugs (212) that are fixable on the solar module support (100);
wherein the anode wire (208) is inserted into one plug (212) and the cathode wire (210) is inserted into the other plug (212) and wherein the solar cell module (20) is adapted to turn off the switching circuit (12) of the solar module support (100) when plugged into the first solar module socket (16) pressing down the resilient members (122).

## Patentansprüche

1. Solarmodulträger (100), welcher umfasst:
ein Substrat (10); und **gekennzeichnet durch**:
einen ersten Umschalt-Schaltkreis (12), der in dem Substrat (10) ausgebildet ist, und der umfasst:
zwei L-förmige Drahtelemente (124);
zwei elastische Elemente (122); und
ein überbrückendes Drahtelement (126); und
eine erste Solarmodulfassung (16), die in dem Substrat (10) angeordnet ist, um ein erstes Solarzellmodul (20) einzurichten, wobei wenn das erste Solarzellmodul (20) mit der ersten Solarmodulfassung (16) in Eingriff kommt, die elastischen Elemente (122) herunter gedrückt werden, so dass die L-förmigen Drahtelemente (124) von dem überbrückenden Drahtelement (126) getrennt werden und ein erster Strom durch das erste Solarzellmodul (20) geht, und wenn das erste Solarzellmodul (20) von der ersten Solarmodulfassung (16) entfernt wird, die elastischen Elemente (122) in ihre entsprechenden Ausgangspositionen zurückkehren, so dass die L-förmigen Drahtelemente (124) mit dem überbrückenden Drahtelement (126) verbunden werden und ein zweiter Strom durch den ersten Umschalt-Schaltkreis (12) geht.

2. Solarmodulträger (100) nach Anspruch 1, weiter **gekennzeichnet durch** einen zweiten Umschalt-Schaltkreis (14), der in dem Substrat (10) ausgebildet ist, und eine zweite Solarmodulfassung (18), die in dem Substrat (10) angeordnet ist, um ein zweites Solarzellmodul (22) einzurichten.

3. Solarmodulträger (100) nach Anspruch 2, **dadurch gekennzeichnet, dass** wenn das erste Solarzellmodul (20) mit der ersten Solarmodulfassung (16) in Eingriff steht, der durch das erste Solarzellmodul (20) gehende erste Strom durch das zweite Solarzellmodul (22) und das erste Solarzellmodul (20) geliefert wird.

4. Solarmodulträger (100) nach Anspruch 2, **dadurch gekennzeichnet, dass** wenn das erste Solarzellmodul (20) von der ersten Solarmodulfassung (16) entfernt wird, der durch den ersten Umschalt-Schaltkreis (12) gehende zweite Strom durch das zweite Solarzellmodul (22) geliefert wird.

5. Solarmodulträger (100) nach Anspruch 2, weiter **gekennzeichnet durch** einen Verbindungsschaltkreis (24), der auf dem Substrat (10) ausgebildet ist und der den ersten Umschalt-Schaltkreis (12) mit dem zweiten Solarzellmodul (22) elektrisch verbindet.

6. Solarmodulträger (100) nach Anspruch 2, weiter **gekennzeichnet durch** einen Verbindungsschaltkreis (24), der auf dem Substrat (10) ausgebildet ist und der das erste Solarzellmodul (20) mit dem zweiten Solarzellmodul (22) elektrisch verbindet.

7. Solarmodulträger (100) nach Anspruch 1, **dadurch gekennzeichnet, dass** das erste Solarzellmodul (20) weiter zwei Stecker (212) umfasst, worin die Stecker (212) geeignet sind, in die erste Solarmodulfassung (16) gesteckt zu werden, um das erste Solarzellmodul (20) auf dem Substrat (10) zu sichern.

8. Solarzellmodul (20), welches ausgestaltet ist auf dem Solarmodulträger (100) nach Anspruch 1 vorzuliegen, welches umfasst:
eine Hinterfolie (206);
eine Vorderfolie (204), die auf der Hinterfolie (206) angeordnet ist;
mindestens eine Solarzelle (202), die zwischen der Vorderfolie (204) und der Hinterfolie (206) angeordnet ist; und
eine Klebeschicht (205), die die mindestens eine Solarzelle (202) umgibt; und **gekennzeichnet durch**:
einen Anodendraht (208), der durch die Klebeschicht (205) und die Hinterfolie (206) geht;
einen Kathodendraht (210), der durch die Klebeschicht (205) und die Hinterfolie (206) geht; und
zwei Stecker (212), die auf dem Solarmodulträger (100) befestigt werden können;
worin der Anodendraht (208) in einen Stecker (212) und der Kathodendraht (210) in den anderen Stecker (212) eingesetzt ist und worin das Solarzellmodul (20) angepasst ist, den Umschalt-Schaltkreis (12) des Solarmodulträgers (100) abzuschalten, wenn es in die erste Solarmodulfassung (16) gesteckt wird und die elastischen Elemente (122) herunter drückt.

## Revendications

1. Support de module solaire (90), comprenant :
un substrat (10) ; et **caractérisé par** :
un premier circuit de commutation (12) conçu dans le substrat (10), comprenant :
deux segments de fil en forme de L (124) ;
deux éléments élastiques (122) ; et
un segment de fil de pontage (126) ; et
un connecteur (16) de premier module solaire disposé dans le substrat (10) pour installer un premier module de cellule solaire (20), où, lorsque le premier module de cellule solaire (20) est en prise avec le connecteur (16) de premier module solaire, les éléments élastiques (122) sont pressés vers le bas de telle sorte que les segments de fil en forme de L (124) sont séparés du segment de fil de pontage (126) et un premier courant passe à travers le premier module de cellule solaire (20) et, lorsque le premier module de cellule solaire (20) se détache du connecteur de premier module solaire (16), les éléments élastiques (122) reviennent à leurs positions respectives d'origine de telle sorte que les segments de fil en forme de L (124) se connectent au segment de fil de pontage (126) et un deuxième courant passe à travers le premier circuit de commutation (12).

2. Support de module solaire (100) selon la revendication 1, **caractérisé en outre par** un deuxième circuit de commutation (14) conçu dans le substrat (10) et par un connecteur (18) de deuxième module solaire disposé dans le substrat (10) pour installer un deuxième module de cellule solaire (22).

3. Support de module solaire (100) selon la revendication 2, **caractérisé en ce que**, lorsque le premier module de cellule solaire (20) est en prise avec le connecteur (16) de premier module solaire, le premier courant passant à travers le premier module de cellule solaire (20) est fourni par le deuxième module de cellule solaire (22) et le premier module de cellule solaire (20).

4. Support de module solaire (100) selon la revendication 2, **caractérisé en ce que**, lorsque le premier module de cellule solaire (20) se détache du connecteur (16) de premier module solaire, le deuxième courant passant à travers le premier circuit de commutation (12) est fourni par le deuxième module de cellule solaire (22).

5. Support de module solaire (100) selon la revendication 2, **caractérisé en outre par** un circuit d'interconnexion (24) conçu sur le substrat (10) et le circuit d'interconnexion (24) connecte électriquement le premier circuit de commutation (12) au deuxième module de cellule solaire (22).

6. Support de module solaire (100) selon la revendication 2, **caractérisé en outre par** un circuit d'interconnexion (24) conçu sur le substrat (10) et le circuit d'interconnexion (24) connecte électriquement le premier module de cellule solaire (20) au deuxième module de cellule solaire (22).

7. Support de module solaire (100) selon la revendication 1, **caractérisé en ce que** le premier module de cellule solaire (20) comprend en outre deux fiches (212) et les fiches (212) sont aptes à s'enficher dans le connecteur (16) de premier module solaire de manière à verrouiller le premier module de cellule solaire (20) sur le substrat (10).

8. Module de cellule solaire (20) conçu pour être fixé sur le support de module solaire (100) selon la revendication 1, comprenant :
une feuille arrière (206) ;
une feuille avant (204) disposée sur la feuille arrière (206) ;
au moins une cellule solaire (202) disposée entre la feuille avant (204) et la feuille arrière (206) ; et
une couche adhésive (205) encapsulant ladite au moins une cellule solaire (202) ; et
**caractérisé par** :
un fil d'anode (208) pénétrant dans la couche adhésive (205) et dans la feuille arrière (206) ;
un fil de cathode (210) pénétrant dans la couche adhésive (205) et dans la feuille arrière (206) ; et
deux fiches (212) qui peuvent être fixées sur le support de module solaire (100) ;
le fil d'anode (208) étant inséré dans une fiche (212) et le fil de cathode (210) étant inséré dans l'autre fiche (212) et
le module de cellule solaire (20) étant conçu pour désactiver le circuit de commutation (12) du support de module solaire (100) lorsqu'il est enfiché dans le connecteur (16) de premier module solaire pressant les éléments élastiques (122) vers le bas.
